# EUROPEAN PATENT APPLICATION

(11) **EP 2 781 631 A1**
(43) Date of publication of application: **24.09.2014**
(21) Application number: 14155482.4
(22) Date of filing: 17.02.2014
(51) Int. Cl.: C30B 25/02, C30B 29/36

(54) **Vapor phase growth apparatus and vapor phase growth method**

(30) Priority: 22.03.2013 JP 2013059830
(71) Applicant: Kabushiki Kaisha Toshiba, Tokyo 105-8001 (JP)
(72) Inventor: Nishio, Johji, Minato-ku, Tokyo 105-8001 (JP); Shimizu, Tatsuo, Minato-ku, Tokyo 105-8001 (JP); Ota, Chiharu, Minato-ku, Tokyo 105-8001 (JP); Shinohe, Takashi, Minato-ku, Tokyo 105-8001 (JP)
(74) Representative: Granleese, Rhian Jane

(57) **Abstract**

A vapor phase growth apparatus of an embodiment includes a reaction chamber, a first gas supply channel that supplies a Si source gas to the reaction chamber, a second gas supply channel that supplies a C source gas to the reaction chamber, a third gas supply channel that supplies an n-type impurity source gas to the reaction chamber, a fourth gas supply channel that supplies a p-type impurity source gas to the reaction chamber, and a control unit that controls the amounts of the n-type impurity and p-type impurity source gases at a predetermined ratio, and introduces the n-type impurity and p-type impurity source gases into the reaction chamber. Where the p-type impurity is an element A and the n-type impurity is an element D, the element A and the element D form a combination of Al, Ga, or In and N, and/or a combination of B and P.

## Description

### CROSS-REFERENCE TO RELATED APPLICATION

This application is based upon and claims the benefit of priority from Japanese Patent Application No. 2013-059830, filed on March 22, 2013, the entire contents of which are incorporated herein by reference.

### FIELD

Embodiments described herein relate generally to a vapor phase growth apparatus and a vapor phase growth method

### BACKGROUND

SiC (silicon carbide) is expected to be a material for next-generation power semiconductor devices. SiC has excellent physical properties, having a band gap three times wider than that of Si (silicon), a breakdown field strength approximately 10 times higher than that of Si, and a heat conductivity approximately three times higher than that of Si. A power semiconductor device that has low loss and is capable of high-temperature operation can be realized by taking advantage of those properties.

SiC is formed on a wafer through epitaxial growth by single wafer processing CVD, for example. Alternatively, SiC is formed on seed crystals through epitaxial growth by high-temperature CVD, for example.

With a conventional vapor phase growth apparatus, however, it is difficult to perform co-doping to simultaneously dope a material with both a p-type impurity and an n-type impurity.

### BRIEF DESCRIPTION OF THE DRAWINGS

FIG. 1 is a schematic cross-sectional view of a vapor phase growth apparatus of a first embodiment;
FIG. 2 is a diagram for explaining the action of co-doping;
FIG. 3 is a diagram for explaining the action of co-doping;
FIG. 4 is a diagram for explaining the action of co-doping;
FIG. 5 is a diagram for explaining the action of co-doping;
FIG. 6 is a diagram for explaining the action of co-doping;
FIG. 7 is a diagram showing the relationship between Al and N concentrations and sheet resistance in the case of n-type SiC;
FIG. 8 is a diagram showing the relationship between N and Al concentrations and sheet resistance in the case of p-type SiC;
FIG. 9 is a schematic cross-sectional view of a semiconductor device of a third embodiment; and
FIG. 10 is a schematic cross-sectional view of a vapor phase growth apparatus of a fourth embodiment.

### DETAILED DESCRIPTION

A vapor phase growth apparatus of an embodiment includes: a reaction chamber; a first gas supply channel that supplies a Si (silicon) source gas to the reaction chamber; a second gas supply channel that supplies a C (carbon) source gas to the reaction chamber; a third gas supply channel that supplies an n-type impurity source gas to the reaction chamber; a fourth gas supply channel that supplies a p-type impurity source gas to the reaction chamber; and a control unit that controls the amounts of the n-type impurity and p-type impurity source gases at a predetermined ratio, and introduces the n-type impurity and p-type impurity source gases into the reaction chamber. Where the p-type impurity is an element A and the n-type impurity is an element D, the element A and the element D form at least a first combination or a second combination, the first combination being a combination of the element A selected from a group consisting of Al (aluminum), Ga (gallium), and In (indium) and the element D being N (nitrogen), the second combination being a combination of the element A being B (boron) and the element D being P (phosphorus).

The following is a description of embodiments, with reference to the accompanying drawings. In the following description, like components are denoted by like reference numerals, and explanation of components described once will not be repeated.

In the following description, n⁺, n, n⁻, p⁺, p, and p⁻ indicate relative levels of impurity concentrations in the respective conductivity types. Specifically, n⁺ indicates that an n-type impurity concentration is relatively higher than that of n, and n⁻ indicates that an n-type impurity concentration is relatively lower than that of n. Likewise, p⁺ indicates that a p-type impurity concentration is relatively higher than that of p, and p⁻ indicates that a p-type impurity concentration is relatively lower than that of p. It should be noted that there are cases where an n⁺ type and an n⁻ type are referred to simply as an n-type, and a p⁺ type and a p⁻ type are referred to simply as a p-type.

### (First Embodiment)

A vapor phase growth apparatus of this embodiment is an apparatus for growing SiC. The vapor phase growth apparatus includes: a reaction chamber; a first gas supply channel that supplies a Si (silicon) source gas to the reaction chamber; a second gas supply channel that supplies a C (carbon) source gas to the reaction chamber; a third gas supply channel that supplies an n-type impurity source gas to the reaction chamber; a fourth gas supply channel that supplies a p-type impurity source gas to the reaction chamber; and a control unit that controls the amounts (flow rates) of the n-type impurity and p-type impurity source gases at a predetermined ratio, and introduces the n-type impurity and p-type impurity source gases into the reaction chamber. If the p-type impurity is an element A and the n-type impurity is an element D, the element A and the element D form a combination of Al (aluminum), Ga (gallium), or In (indium) and N (nitrogen), and/or a combination of B (boron) and P (phosphorus). In the following, an example case where the element A is Al (aluminum) and the element D is N (nitrogen) is described. In other words, the element A and the element D form at least a first combination or a second combination, the first combination being a combination of the element A selected from a group consisting of Al (aluminum), Ga (gallium), and In (indium) and the element D being N (nitrogen), the second combination being a combination of the element A being B (boron) and the element D being P (phosphorus).

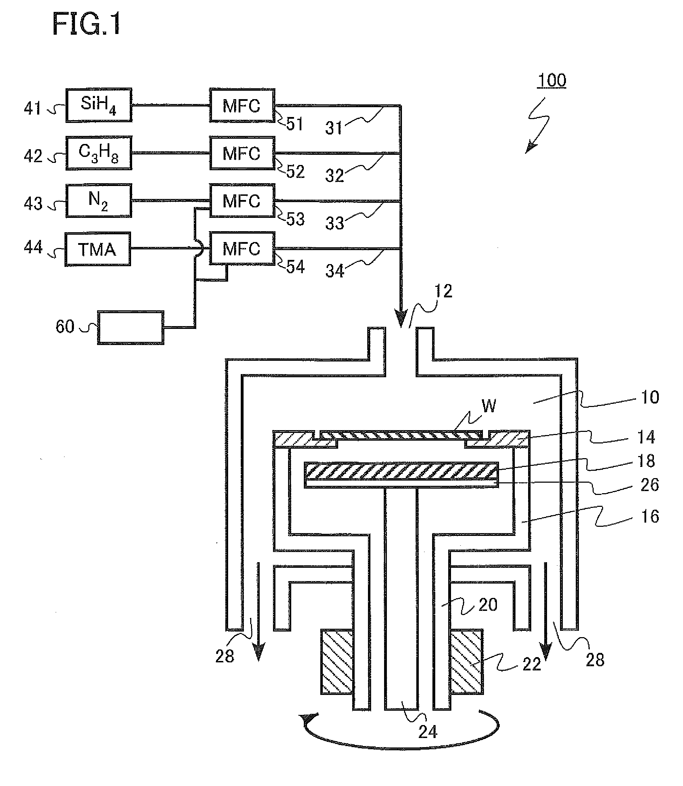

FIG. 1 is a schematic cross-sectional view of the vapor phase growth apparatus of this embodiment. The vapor phase growth apparatus of this embodiment is a single wafer processing epitaxial growth apparatus.

As shown in FIG. 1, the epitaxial growth apparatus 100 of this embodiment includes a cylindrical, hollow reaction chamber 10 that is made of stainless steel, for example. A gas supply unit 12 is placed on the reaction chamber 10, and supplies process gases such as source gases into the reaction chamber 10.

A supporting unit 14 is further placed below the gas supply unit 12 in the reaction chamber 10, and is capable of having a semiconductor wafer (a substrate) W placed thereon. The supporting unit 14 may be a ring-like holder that has an opening at the center, or may be a susceptor in contact with almost the entire bottom face of the semiconductor wafer W, for example.

A rotator unit 16 that has the supporting unit 14 placed on the upper surface thereof and rotates is also placed under the supporting unit 14. Further, a heater as a heating unit 18 that heats the wafer W placed on the supporting unit 14 with radiation heat is placed below the supporting unit 14.

Here, the rotator unit 16 has its rotating shaft 20 connected to a rotating drive mechanism 22 located at a lower portion thereof. The rotating drive mechanism 22 can rotate the semiconductor wafer W about the rotation center thereof at a high speed of 300 to 1000 rpm, for example.

The cylindrical rotating shaft 20 is also connected to a vacuum pump (not shown) for evacuating the hollow rotator unit 16. The semiconductor wafer W may be in vacuum contact with the supporting unit 14 by virtue of suction by the vacuum pump. The rotating shaft 20 is rotatably provided at a bottom portion of the reaction chamber 10 via a vacuum sealing member.

The heating unit 18 is fixed onto a support table 26 that is fixed to a support shaft 24 penetrating through the inside of the rotating shaft 20. An upthrust pin (not shown) for detaching the semiconductor wafer W from the ring-like holder 14 may be provided in this support table 26.

Further, a gas emission unit 28 that discharges the reaction product generated after a source gas reaction in the surface or the like of the semiconductor wafer W and the residual gas in the reaction chamber 10 out of the reaction chamber 10 is provided at a bottom portion of the reaction chamber 10. The gas emission unit 28 is connected to the vacuum pump (not shown).

The epitaxial growth apparatus 100 of this embodiment further includes a first gas supply channel 31 that supplies a Si (silicon) source gas to the reaction chamber 10, a second gas supply channel 32 that supplies a C (carbon) source gas to the reaction chamber 10, a third gas supply channel 33 that supplies an N (nitrogen) source gas to the reaction chamber 10, and a fourth gas supply channel 34 that supplies an Al (aluminum) source gas to the reaction chamber 10.

The first gas supply channel 31 is connected to a first gas supply source 41, the second gas supply channel 32 is connected to a second gas supply source 42, the third gas supply channel 33 is connected to a third gas supply source 43, and the fourth gas supply channel 34 is connected to a fourth gas supply source 44. The first through fourth gas supply sources 41 through 44 are gas cylinders filled with the respective source gases, for example.

The Si (silicon) source gas may be monosilane (SiH₄) having a hydrogen gas (H₂) as the carrier gas, for example. The C (carbon) source gas may be propane (C₃H₈) having a hydrogen gas as the carrier gas, for example. The N (nitrogen) source gas may be a nitrogen gas (N₂), for example. The Al (aluminum) source gas may be trimethylaluminum (TMA) that is bubbled with a hydrogen gas (H₂) and has the hydrogen gas (H₂) as the carrier gas, for example.

The vapor phase growth apparatus 100 of this embodiment further includes: a mass flow controller 51 that is connected to the first gas supply source 41 and adjusts the flow rate of the Si (silicon) source gas; a mass flow controller 52 that is connected to the second gas supply source 42 and adjusts the flow rate of the C (carbon) source gas; a mass flow controller (a first adjusting unit) 53 that is connected to the third gas supply source 43 and adjusts the flow rate of the N (nitrogen) source gas; and a mass flow controller (a second adjusting unit) 54 that is connected to the fourth gas supply source 44 and adjusts the flow rate of the Al (aluminum) source gas.

The vapor phase growth apparatus 100 also includes a control signal generating unit 60 that generates control signals that set flow rates in the first adjusting unit 53 and the second adjusting unit 54. The first adjusting unit 53 and the second adjusting unit 54, and the control signal generating unit 60 constitute a control unit that adjusts the flow rates of the N source gas and the Al source gas to desired flow rates.

The control signal generating unit 60 may be a computer that has the function to calculate such flow rates of the N source gas and the Al source gas that realize a desired concentration ratio between N and Al in the SiC film, for example. The control signal generating unit 60 generates control signals by calculating the flow rates required for the N source gas and the Al source gas based on the concentration ratio between N and Al in SiC that is input from an external input device and is to be realized.

In the control unit, the first adjusting unit 53 and the second adjusting unit 54 may have the above described function of the control signal generating unit 60.

With the vapor phase growth apparatus 100 of this embodiment, an SiC film can be formed by simultaneously supplying an N (nitrogen) source gas as the n-type impurity and an Al (aluminum) source gas as the p-type impurity. Accordingly, an epitaxial SiC film co-doped with N (nitrogen) as the n-type impurity and Al (aluminum) as the p-type impurity can be formed.

Further, with the control unit that adjusts the flow rates of the N source gas and the Al source gas, the flow rates of the N source gas and the Al source gas can be adjusted to desired flow rates. Accordingly, the ratio between the Al concentration and the N concentration in the SiC being grown can be adjusted to a desired ratio.

Low-resistance SiC can be realized by co-doping SiC with N (nitrogen) as the n-type impurity and Al (aluminum) as the p-type impurity at a predetermined ratio as described above.

Particularly, the control unit is preferably designed to adjust the flow rates of the Al source gas and the N source gas so that the ratio of the Al concentration to the N concentration in the SiC being grown becomes higher than 0.40 but lower than 0.95, or the ratio of the N concentration to the Al concentration in the SiC being grown becomes higher than 0.33 but lower than 1.0.

In the following, low-resistance SiC that can be manufactured by the vapor phase growth apparatus of this embodiment and is co-doped with an n-type impurity and a p-type impurity is described in detail.

It has become apparent from the results of studies made by the inventors that pairing between Al and N can be caused by co-doping SiC with Al as the p-type impurity (p-type dopant) and N as the n-type impurity (n-type dopant). In this pairing state, carriers are compensated and are put into a zero state.

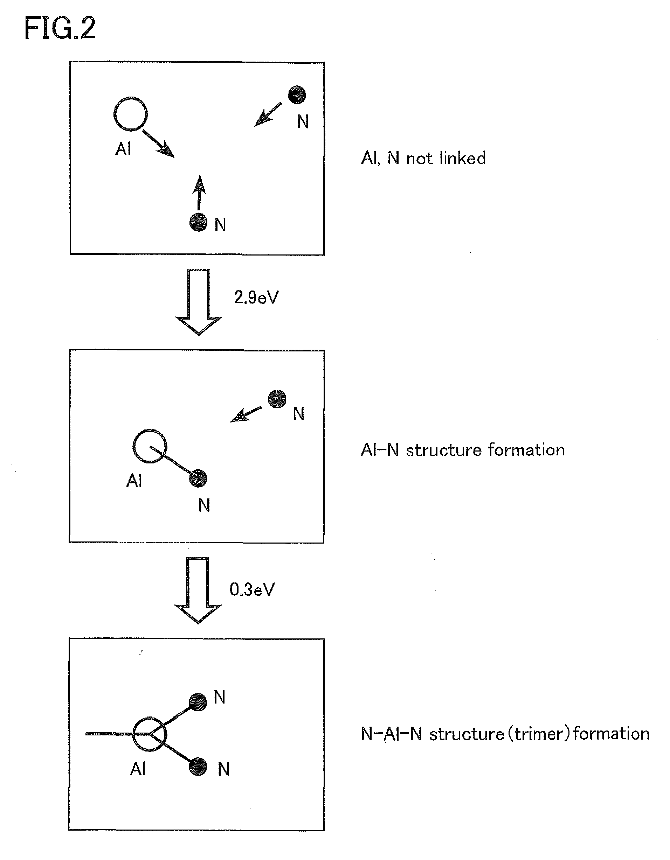

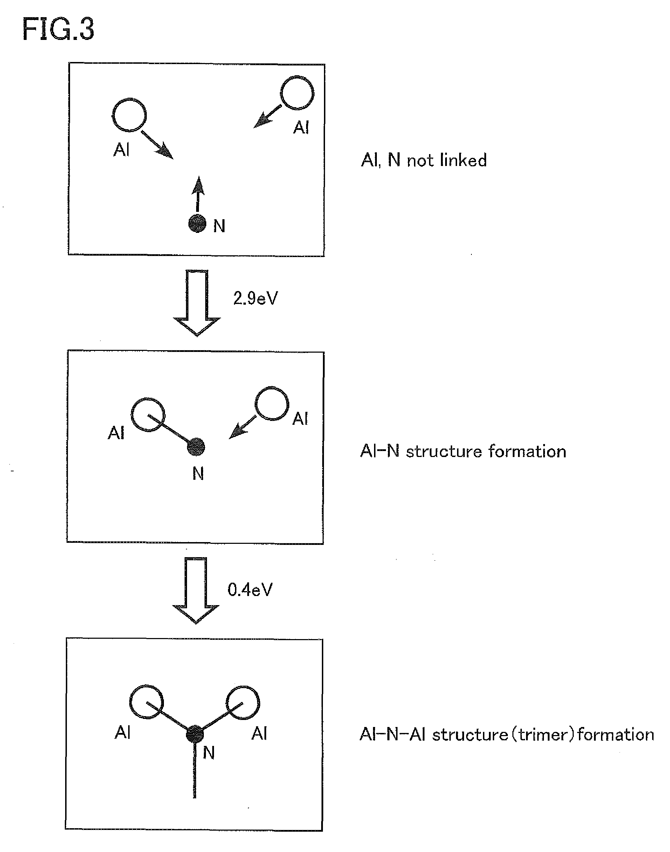

FIGS. 2 and 3 are diagrams for explaining the action of co-doping. FIG. 2 shows the case of n-type SiC, and FIG. 3 shows the case of p-type SiC. It has become apparent from the first principle calculation performed by the inventors that Al enters Si (silicon) sites and N enters C (carbon) sites in SiC so that Al and N become adjacent to each other, and, as a result, the system becomes more stable.

Specifically, as shown in FIGS. 2 and 3, where Al and N are linked to each other to form an Al-N pair structure, the system becomes 2.9 eV more stable in terms of energy than that in a situation where Al and N are not linked to each other but exist independently of each other. If the Al amount and the N amount are the same, the most stable state is achieved as all of the two elements form pair structures.

Here, the first principle calculation is a calculation using ultrasoft pseudopotential. Ultrasoft pseudopotential is a type of pseudopotential, and was developed by Vanderbilt et al. For example, a lattice constant has such a high precision as to realize experimental values with a margin of error of 1% or smaller. Structural relaxation is achieved by introducing impurities (dopant), and the entire energy of a stable state is calculated. The energy of the entire system after a change is compared with the energy prior to the change, so as to determine which structures are in a stable state. In a stable state, the energy position of the impurity level in the band gap can be indicated.

As shown in FIG. 2, it has become apparent that, in a case where the amount of N is larger than the amount of Al, or in the case of n-type SiC, extra N enters C sites located in the vicinity of an Al-N pair structure, to form N-Al-N trimers and further stabilize the system. According to the first principle calculation, trimers are formed, and the system becomes 0.3 eV more stable than that in a case where pair structures exist separately from N.

Likewise, as shown in FIG. 3, it has become apparent that, in a case where the amount of Al is larger than the amount of N, or in the case of p-type SiC, extra Al enters Si sites located in the vicinity of an Al-N pair structure, to form Al-N-Al trimers and further stabilize the system. According to the first principle calculation, trimers are formed, and the system becomes 0.4 eV more stable than that in a case where Al-N pair structures exist separately from Al.

Next, a dopant combination other than the combination of Al and N is discussed. Calculation results obtained in a case where a calculation was conducted for a combination of B (boron) and N (nitrogen) are described below.

B enters Si sites, and N enters C sites. According to the first principle calculation, B-N-B or N-B-N trimeric structures cannot be formed. Specifically, B-N pair structures are formed, but the energy of the system becomes higher when B or N approaches the B-N pair structures. Accordingly, the system is more stable in terms of energy when extra B or N exists independently in positions sufficiently away from the pair structures.

According to the first principle calculation, when extra B forms trimers, the energy of the system is 0.5 eV higher than that in a case where B-N pairs exist independently of B. Also, when extra N forms trimers, the energy of the system is 0.3 eV higher than that in a case where B-N pairs exist independently of N. Therefore, in either case, the system becomes unstable in terms of energy when trimers are formed.

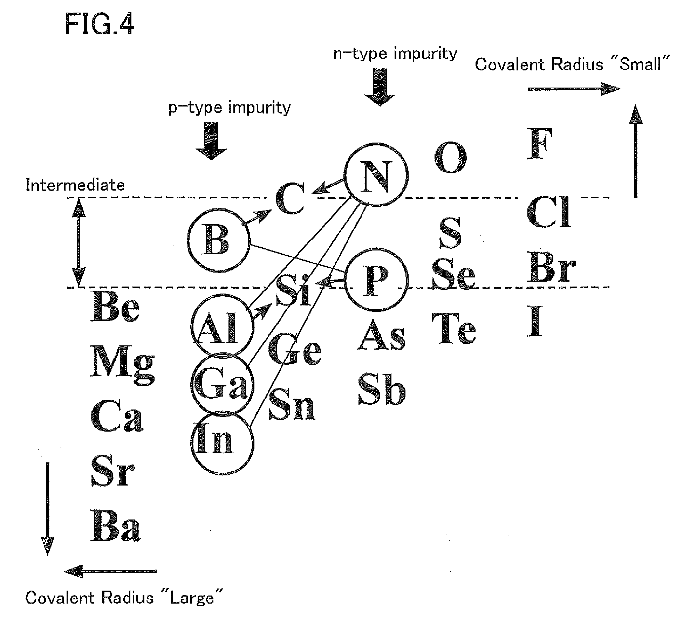

FIG. 4 is a diagram for explaining the action of co-doping. FIG. 4 shows the covalent radii of respective elements. Elements with smaller covalent radii are shown in the upper right portion in the drawing, and elements with larger covalent radii are shown in the lower left portion.

Considering the covalent radii, it is understandable that the system becomes unstable when trimers are formed with B and N. The covalent radius of B is smaller than the covalent radius of Si, and the covalent radius of N is smaller than the covalent radius of C. Therefore, when B enters Si sites and N enters C sites, strain accumulates, and trimers cannot be formed.

It has become apparent that trimers are not formed with combinations of the p-type impurity and the n-type impurity as dopant other than the combinations of "an element (Al, Ga, or In) having a larger covalent radius than that of Si" and "an element (N) having a smaller covalent radius than that of C" and the reverse combination of "an element (B) having a larger covalent radius than that of C" and "an element (P) having a smaller covalent radius than that of Si".

Since the covalent radii of B and P are between the covalent radius of Si and the covalent radius of C, B and P can enter both Si sites and C sites. However, the other impurities (Al, Ga, In, N, and As) basically enter either Si sites or C sites. It is safe to say that Al, Ga, In, and As enter Si sites, and N enters C sites.

Furthermore, when both impurities enter Si sites or both impurities enter C sites, there is no need to consider such matter. This is because it is difficult to relax strain unless the p-type impurity and the n-type impurity are located at the closest distance from each other. Therefore, where the p-type impurity is the element A and the n-type impurity is the element D, it is difficult to form trimers with combinations of the element A and the element D other than the four combinations of Al and N, Ga and N, In and N, and B and P.

The pair structures or the trimeric structures cannot be formed unless there is interaction between atoms. If approximately 10 unit cells exist in the c-axis direction, the interaction becomes invisible, and the impurity level (dopant level) in a 4H-SiC structure according to the first principle calculation becomes flat. That is, diffusion is sufficiently restrained, and is on the order of approximately 10 meV.

In other words, it is considered that there is little interaction when the distance between impurities is 10 nm or longer. In view of this, to maintain interaction between impurities, the impurity concentration is preferably 1 × 10¹⁸ cm⁻³ or higher.

This value is the lower limit of the impurity concentration that is desired when a local impurity distribution is formed through ion implantation in a case where an SiC material has already been formed.

To cause an effect of co-doping to appear in semiconductor SiC, the ratio between the n-type impurity concentration and the p-type impurity concentration needs to be restricted within a specific range. By the later described manufacturing method, it is critical that the ratio between the n-type and p-type impurities to be introduced by ion implantation be set at a ratio within the specific range from the start. Although the reach of interaction is as small as less than 10 nm, trimers can be formed by virtue of the attraction force of each other within the reach. Furthermore, as the attraction force is applied, the temperature of the activating anneal for the impurities can be lowered from 1700-1900°C, which is the temperature range in a case where co-doping is not performed, to 1500-1800°C.

However, the impurity concentration desirable for trimer formation can be lowered in crystal growth from a vapor phase by CVD (Chemical Vapor Deposition) method or the like. This is because raw material can be made to flow in the surface, and accordingly, interaction between the impurities can easily occur at low concentrations.

In vapor phase growth, the range of impurity concentrations for trimer formation is 1 × 10¹⁵ cm⁻³ to 1 × 10²² cm⁻³, which is wider than that with ion implantation. In vapor phase growth, it is possible to lower the impurity concentration in SiC to approximately 1 × 10¹⁶ cm⁻³ or increase the impurity concentration in SiC to approximately 1 × 10²¹ cm⁻³, for example. Particularly, it is difficult to form an impurity region in a low-concentration region through ion implantation. Therefore, impurity region formation through vapor phase growth is particularly effective in a low-concentration region. Furthermore, it is possible to form a co-doped film as thin as 5 nm, for example, through vapor phase growth.

Vapor phase growth also has the advantage that defects in crystals are not easily formed in regions containing impurities at high concentrations. In the case of ion implantation, defects in crystals increase as the amount of introduced impurities becomes larger, and recovery through a heat treatment or the like also becomes difficult. By vapor phase growth, trimers are formed during the growth, and defects due to impurity implantation are hardly formed. In view of this, impurity region formation through vapor phase growth is effective in regions having impurity concentrations of 1 × 10¹⁹ cm⁻³ or higher, or more preferably, 1 × 10²⁰ cm⁻³ or higher, for example.

As described above, vapor phase growth has effects that cannot be achieved by ion implantation. However, impurity regions that are locally co-doped can be formed through ion implantation. Also, co-doped impurity regions can be formed at low costs. Therefore, either vapor phase growth or ion implantation should be used where appropriate.

When trimers are to be formed at the time of crystal growth from a vapor phase, the concentrations of the p-type and n-type impurities are preferably 1 × 10¹⁵ cm⁻³ or higher. Further, so as to facilitate the trimer formation, the impurity concentrations are preferably 1 × 10¹⁶ cm⁻³ or higher.

When trimers are formed, the upper limit of impurity concentrations may exceed the solid solubility limit of cases where trimers are not formed. This is because, when trimers are formed, strain in crystals is relaxed, and the impurities are easily solved.

The impurity solid solubility limit in a case where trimers are not formed is on the order of 10¹⁹ cm⁻³ in the case of N, and is on the order of 10²¹ cm⁻³ even in the case of Al. As for the other impurities, the solid solubility limit is on the order of approximately 10²¹ cm⁻³.

When only one type of impurity is used, the size of the impurity is either small or large. Therefore, strain accumulates, and the impurity cannot easily enter lattice points. As a result, activation cannot be caused. Particularly, in the case of ion implantation, a large number of defects are formed, and the solid solubility limit becomes even lower.

However, when trimers are formed, both Al and N can be implanted up to the order of approximately 10²² cm⁻³. As strain can be relaxed by forming trimers with one of the four combinations of Al and N, Ga and N, In and N, and B and P, the solid solubility limit can be extended. As a result, the impurity solid solubility limit can be extended to the order of 10²² cm⁻³

In a case where the impurity is B, Al, Ga, In, or P, strain is large, and a large number of defects exist, if the impurity concentration is 1 × 10²⁰ cm⁻³ or higher, or more particularly, 6 × 10²⁰ cm⁻³ or higher. As a result, sheet resistance or resistivity becomes very high.

However, co-doping with the p-type impurity and the n-type impurity can reduce defects even in regions having such high impurity concentrations.

When an impurity is N, the solid solubility limit is further lowered by one digit to approximately 2 × 10¹⁹ cm⁻³. According to the first principle calculation, this is probably because defects of inactive interstitial N are formed.

As trimers are formed, the upper limit of the N concentration is dramatically increased from the order of 10¹⁹ cm⁻³ to the order of 10²² cm⁻³. In a case where an n-type region doped at a high concentration is to be formed, nitrogen cannot be normally used, and P ions are implanted at approximately 10²⁰ cm⁻³, for example. In this embodiment, however, an n-type region doped at a high concentration can be formed by using nitrogen. For example, N is implanted at 2 × 10²⁰ cm⁻³, and Al is implanted at 1 × 10²⁰ cm⁻³. It has been difficult to use nitrogen, but nitrogen can be used in this embodiment.

As described above, both the p-type impurity and the n-type impurity are implanted, and an appropriate combination of covalent radii is selected, so that trimers can be formed. The structures are then stabilized, and strain can be reduced.

As a result, (1) the respective impurities can easily enter lattice points,(2) the process temperature can be lowered, and a temperature decrease of at least 100°C can be expected, (3) the amount of impurities that can be activated increases (the upper limit is extended),(4) stable structures such as trimers or pair structures can be formed, andentropy is increased and crystal defects are reduced with the structures, and(5) as the trimers are stable, revolutions around the bonds that bind the p-type impurity and the n-type impurity become difficult, and the structures are immobilized. Accordingly, energization breakdown tolerance becomes dramatically higher. For example, when trimeric structures are formed in at least part of the p-type impurity region and the n-type impurity region of a pn junction, energization breakdown is restrained, and an increase in resistance can be avoided. As a result, a degradation phenomenon (Vf degradation) in which the applied voltage (Vf) required in applying a certain amount of current can be restrained.

As described above, pairing between Al and N can be caused by co-doping with Al as the p-type impurity and N as the n-type impurity. Furthermore, it has become apparent from the first principle calculation that both acceptor levels and donor levels can be made shallower at this point.

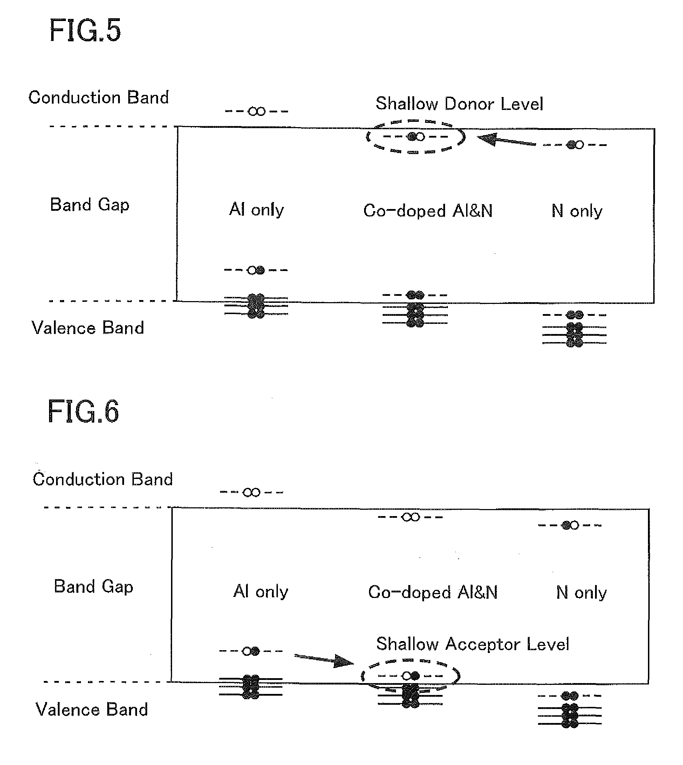

FIGS. 5 and 6 are diagrams for explaining the action of co-doping. FIG. 5 illustrates a case of n-type SiC, and FIG. 6 illustrates a case of p-type SiC. White circles represent empty levels not filled with electrons, and black circles represent levels filled with electrons.

The reason that the donor levels become shallower is that the empty levels located within the conduction band of Al as the acceptor interact with the donor levels of N, and the donor levels are raised, as shown in FIG. 5. Likewise, the reason that the acceptor levels become shallower is that the levels that are filled with electrons and are located within the valence band of N as the donor interact with the acceptor levels of Al, and the acceptor levels are lowered, as shown in FIG. 6.

Normally, N or P (phosphorus) as the n-type impurity forms donor levels that are as deep as 42 to 95 meV. B, Al, Ga, or In as the p-type impurity forms very deep acceptor levels of 160 to 300 meV. If trimers are formed, on the other hand, the n-type impurity can form donor levels of 35 meV or less, and the p-type impurity can form acceptor levels of 100 meV or less.

In an optimum state where trimers are completely formed, n-type N or P forms levels of approximately 20 meV, and p-type B, Al, Ga, or In forms levels of approximately 40 meV. As such shallow levels are formed, most of the activated impurities turn into carriers (free electrons and free holes). Accordingly, the bulk resistance becomes one or more digits lower than that in a case where co-doping is not performed.

In the case of n-type SiC, the donor levels that contribute to carrier generation becomes 40 meV or less, and as a result, the resistance becomes lower than that in a case where co-doping is not performed. Also, as the donor levels become 35 meV or less, the resistance is lowered by approximately one digit. As the donor levels become 20 meV or less, the resistance is lowered by approximately two digits. However, a strain relaxation effect and a doping upper limit extension effect are also achieved.

In the case of p-type SiC, the acceptor levels that contribute to carrier generation becomes 150 meV or less, and as a result, the resistance becomes lower than that in a case where co-doping is not performed. Also, as the acceptor levels become 100 meV or less, the resistance is lowered by approximately one digit. As the acceptor levels become 40 meV or less, the resistance is lowered by approximately two digits. However, a strain relaxation effect and a doping upper limit extension effect are also achieved.

When the Al concentration and the N concentration are the same (N : Al = 1 : 1), an insulator is formed, because there are no carriers though there are shallow levels. Carriers that are equivalent to a difference between the Al concentration and the N concentration are generated. To form a low-resistance semiconductor, a concentration difference is required.

When the N concentration is higher than the Al concentration (N concentration > Al concentration), extra N generated as a result of formation of Al-N pairs through interaction is also stabilized by displacing C located in the vicinities of the Al-N pairs. Accordingly, shallow donor levels are formed. Also, strain is relaxed. Accordingly, the N concentration can be made higher than that in a case where trimers are not formed.

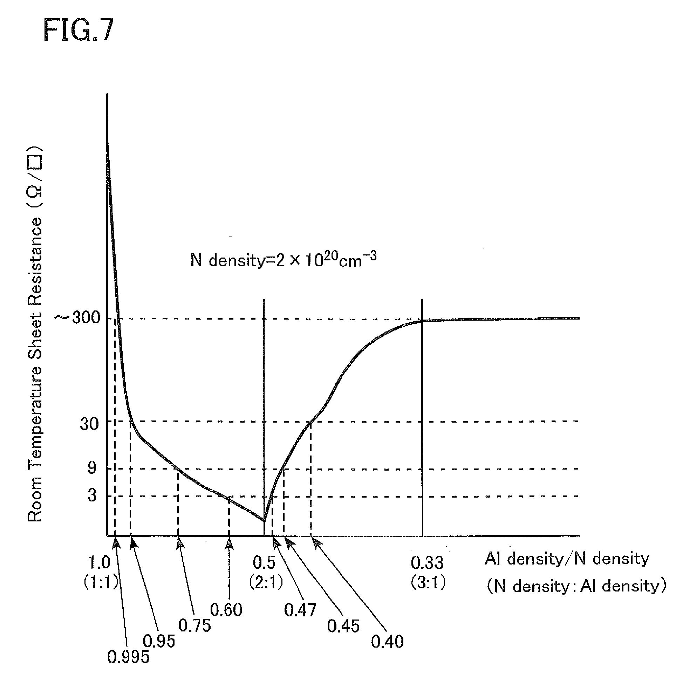

FIG. 7 is a diagram showing the relationship between Al and N concentrations and sheet resistance in the case of n-type SiC. The N concentration is 2 × 10²⁰ cm⁻³. When only N is implanted, the sheet resistance cannot be lowered even if N is implanted at 1 × 10¹⁹ cm⁻³ or higher. The value is approximately 300 Ω/□.

While "N concentration : Al concentration" is changing from 1 : 1 to 2 : 1, trimers are formed without strain, and the number of carrier electrons in the shallow donor levels increases. Accordingly, the sheet resistance rapidly decreases.

When the ratio reaches 2 : 1, the maximum amount of carriers is available, and the sheet resistance becomes lowest. As shown in FIG. 7, the sheet resistance can be lowered down to approximately 1.5 Ω/□. The contact resistance to n-type SiC can also be lowered from approximately 10⁻⁵ Ωcm³ to approximately 10⁻⁷ Ωcm³ by making "N concentration : Al concentration" equal to 2 : 1 and increasing the difference between the N concentration and the Al concentration from 10²⁰ cm⁻³ to 10²² cm⁻³.

Furthermore, if the ratio of the N concentration becomes higher than 2 : 1, the original deep donor levels are formed by the extra N that exceeds "N concentration : Al concentration = 2 : 1". The donor levels receive carrier electrons, and the shallow donor levels formed with trimers become empty. The excess N left out from "N concentration : Al concentration = 2 : 1" is similar to N introduced independently. Therefore, strain relaxation is difficult. As a result, the sheet resistance rapidly increases as shown in FIG. 7.

In FIG. 7, the target for comparison is the sheet resistance (approximately 300 Ω/□ in this case) in a case where N (nitrogen) as the n-type impurity is implanted almost up to the solid solubility limit when co-doping with Al is not performed, and changes in the sheet resistance value seen when "N concentration : Al concentration" is changed from 2 : 1 are shown.

The following description centers around "Al concentration/N concentration = 0.5", at which trimer structures are formed. In a case where "Al concentration/N concentration" is not lower than 0.47 and not higher than 0.60 (100% of the carriers of 8 × 10¹⁹ cm⁻³ or higher being free carriers), or where the p-type impurity at 47 to 60% with respect to the n-type impurity is implanted, the sheet resistance is two digits lower than the sheet resistance obtained in a case co-doping with Al is not performed. Such a concentration ratio is highly advantageous. When the ratio is lower than 0.5, shallow levels decrease, and strain is caused. As a result, the number of free carriers decreases, and carriers equivalent to 8 × 10¹⁹ cm⁻³ are obtained when the ratio is approximately 0.47.

In a case where the range is widened in both directions, and "Al concentration/N concentration" is not lower than 0.45 and not higher than 0.75 (100% of the carriers of 5 × 10¹⁹ cm⁻³ or higher being free carriers), or where Al at 45 to 75% with respect to N is implanted, the sheet resistance ranges from a two-digit-lower resistance to a resistance almost three times higher than the two-digit-lower resistance. When the ratio is lower than 0.5, shallow levels decrease, and strain is caused. As a result, the number of free carriers decreases, and carriers equivalent to 5 × 10¹⁹ cm⁻³ are obtained when the ratio is approximately 0.45. In a case where the range is further widened in both directions and "Al concentration/N concentration" is higher than 0.40 but lower than 0.95 (100% of the carriers of 1 × 10¹⁹ cm⁻³ or higher being free carriers), or where Al at 40 to 95% with respect to N is implanted, the sheet resistance becomes one digit lower. When the ratio is lower than 0.5, shallow levels decrease, and strain is caused. As a result, the number of free carriers decreases, and carriers equivalent to 1 × 10¹⁹ cm⁻³ are obtained when the ratio is approximately 0.40.

Better characteristics are achieved on the side where Al at 50% or more with respect to N is implanted, because strain is sufficiently relaxed. The 50% state is the state where two N atoms and one Al atom are clustered to form a trimer. When the ratio is lower than 50%, trimers are formed, and extra N exists. Since there is N that cannot form trimers, an equivalent amount of strain accumulates. N that cannot form trimers is the same as that introduced independently, and reaches the limit of strain in no time. When the amount of Al is lower than 50%, strain rapidly occurs, and lattice defects increase. Therefore, the sheet resistance rapidly deteriorates when the ratio is lower than 50%, compared with that in a case where the ratio is 50% or higher at which strain can be relaxed.

When "Al concentration/N concentration" is 0.995, the number of carriers is almost the same as that in a case where co-doping is not performed. Since 100% of the carriers of 1 x 10¹⁸ cm⁻³ or higher, which is 0.5% of 2 × 10²⁰ cm⁻³, are free carriers, the sheet resistance to be obtained with conventional nitrogen doping can be realized. Accordingly, the sheet resistance is almost the same as that in a case where co-doping is not performed. In a case where "Al concentration/N concentration" is 0.33 or where "N concentration : Al concentration" is 3 : 1, all carrier electrons are received not by shallow donor levels formed with trimers but by deep donor levels formed with extra N. Accordingly, the sheet resistance is almost the same as that in a case where co-doping is not performed. Therefore, the resistance is lowered by co-doping in cases where "Al concentration/N concentration" is higher than 0.33 but lower than 0.995, or where Al at 33 to 99.5% with respect to N is implanted. With the margin of error being taken into account, it can be considered that the ratio of Al to N should be higher than 33% but lower than 100%.

When the Al concentration is higher than the N concentration (Al concentration > N concentration), extra Al generated as a result of formation of Al-N pairs through interaction is also stabilized by displacing Si located in the vicinities of the Al-N pairs. Accordingly, shallow acceptor levels are formed. Also, strain is relaxed. Accordingly, the Al concentration can be made higher than that in a case where trimers are not formed. This case can be considered to be the same as the case where the N concentration is higher than the Al concentration.

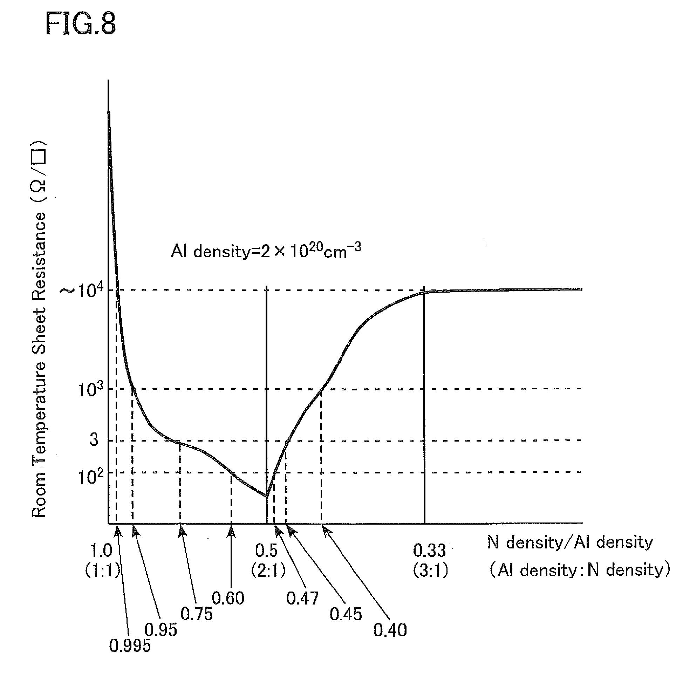

FIG. 8 is a diagram showing the relationship between N and Al concentrations and sheet resistance in the case of p-type SiC. The Al concentration is 2 × 10²⁰ cm⁻³.

While "Al concentration : N concentration" is changing from 1 : 1 to 2 : 1, trimers are formed without strain, and the number of carrier holes in the shallow acceptor levels increases. Accordingly, the sheet resistance decreases.

When the ratio reaches 2 : 1, the maximum amount of carriers is available, and the sheet resistance becomes lowest. As shown in FIG. 8, the sheet resistance can be lowered down to approximately 40 Ω/□. The contact resistance to p-type SiC can also be lowered from approximately 10⁻⁵ Ωcm³ to approximately 10⁻⁷ Ωcm³ by making "Al concentration : N concentration" equal to 2 : 1 and increasing the difference between the Al concentration and the N concentration from 10²⁰ cm⁻³ to 10²² cm⁻³.

Furthermore, if the ratio of the Al concentration becomes higher than 2 : 1, the original deep acceptor levels are formed by the extra Al that exceeds "Al concentration : N concentration = 2 : 1". The acceptor levels receive carrier holes, and the shallow acceptor levels formed with trimers are filled with electrons. The excess Al left out from "Al concentration : N concentration = 2 : 1" is similar to N introduced independently. Therefore, strain relaxation is difficult. As a result, the sheet resistance rapidly increases as shown in FIG. 8.

In FIG. 8, the target for comparison is the sheet resistance (approximately 10 KΩ/□ in this case) in a case where Al (aluminum) as the p-type impurity is implanted almost up to the solid solubility limit when co-doping with N is not performed, and changes in the sheet resistance value seen when "Al concentration : N concentration" is changed from 2 : 1 are shown.

The following description centers around "N concentration/Al concentration = 0.5", at which trimer structures are formed. In a case where "N concentration/Al concentration" is not lower than 0.47 and not higher than 0.60 (100% of the carriers of 8 × 10¹⁹ cm⁻³ or higher being free carriers), or where the n-type impurity at 47 to 60% with respect to the p-type impurity is implanted, the sheet resistance is two digits lower than the sheet resistance obtained in a case co-doping with N is not performed. Such a concentration ratio is highly advantageous. When the ratio is lower than 0.5, shallow levels decrease, and strain is caused. As a result, the number of free carriers decreases, and carriers equivalent to 8 × 10¹⁹ cm⁻³ are obtained when the ratio is approximately 0.47.

In a case where the range is widened in both directions, and "N concentration/Al concentration" is not lower than 0.45 and not higher than 0.75 (100% of the carriers of 5 × 10¹⁹ cm⁻³ or higher being free carriers), or where N at 45 to 75% with respect to Al is implanted, the sheet resistance ranges from a two-digit-lower resistance to a resistance almost three times higher than the two-digit-lower resistance. When the ratio is lower than 0.5, shallow levels decrease, and strain is caused. As a result, the number of free carriers decreases, and carriers equivalent to 5 × 10¹⁹ cm⁻³ are obtained when the ratio is approximately 0.45. In a case where the range is further widened in both directions and "N concentration/Al concentration" is higher than 0.40 but lower than 0.95 (100% of the carriers of 1 × 10¹⁹ cm⁻³ or higher being free carriers), or where N at 40 to 95% with respect to Al is implanted, the sheet resistance becomes one digit lower. When the ratio is lower than 0.5, shallow levels decrease, and strain is caused. As a result, the number of free carriers decreases, and carriers equivalent to 1 × 10¹⁹ cm⁻³ are obtained when the ratio is approximately 0.40.

Better characteristics are achieved on the side where N at 50% or more with respect to Al is implanted, because strain is sufficiently relaxed. When N is less than 50%, on the other hand, trimers formed with one N atom and two Al atoms that are clustered account for 50% of the entire structure, and further, Al exists therein. Since there is Al that cannot form trimers, an equivalent amount of strain accumulates. When the amount of N is lower than 50%, strain rapidly occurs, and lattice defects increase. Therefore, the sheet resistance rapidly deteriorates when the ratio is lower than 50%, compared with that in a case where the ratio is 50% or higher at which strain can be relaxed.

At this point, "N concentration/Al concentration" is 0.995, and the number of carriers is almost the same as that in a case where co-doping is not performed. Since 100% of the carriers of 1 × 10¹⁸ cm⁻³ or higher, which is 0.5% of 2 × 10²⁰ cm⁻³, are free carriers, the sheet resistance to be obtained with conventional Al doping can be realized. Accordingly, the sheet resistance is almost the same as that in a case where co-doping is not performed. In a case where "N concentration/Al concentration" is 0.33 or where "Al concentration : N concentration" is 3 : 1, all carrier holes are received not by shallow acceptor levels formed with trimers but by deep acceptor levels formed with extra Al. Accordingly, the sheet resistance is almost the same as that in a case where co-doping is not performed. Therefore, a resistance lowering effect is achieved by co-doping in cases where "N concentration/Al concentration" is higher than 0.33 but lower than 0.995, or where N at 33 to 99.5% with respect to Al is implanted. With the margin of error being taken into account, it can be considered that the ratio of Al to N should be higher than 33% but lower than 100%.

When co-doping is not performed, a low-resistance SiC semiconductor material containing impurities having low concentrations of 1 × 10¹⁸ cm⁻³ or lower cannot exist. However, when trimers are formed by co-doping, shallow levels are formed, and the number of carriers increases. Accordingly, a reduction in resistance can be achieved with small amounts of impurities.

Co-doping with the p-type impurity and the n-type impurity at an appropriate ratio as described above can achieve at least two notable effects.

First, strain is relaxed, and SiC with less strain can be formed. Compared with a case where co-doping is not performed, strain is smaller, the number of defects is smaller, and larger amounts of impurities can be implanted. That is, the solid solubility limits of impurities can be raised. Accordingly, the sheet resistance, the resistivity, and the contact resistance are lowered. As fewer defects are formed by either ion implantation or epitaxial growth, dosing of large amounts of impurities can be performed.

Secondly, shallow levels can be formed. Compared with a case where co-doping is not performed, a low-resistance material can be formed with smaller amounts of impurities. Alternatively, a sheet resistance that is one or more digits lower can be achieved with the same amounts of impurities as those in a case where co-doping is not performed. In a region that can be formed through epitaxial growth and contains a low-dose impurity, the resistance becomes higher unless co-doping is performed. However, low-resistance SiC can be formed when co-doping is performed. Accordingly, an SiC semiconductor device having a lower ON resistance can be manufactured.

Referring back to FIG. 1, a vapor phase growth method using the vapor phase growth apparatus of this embodiment is described. First, a method of growing n-type SiC is described.

According to the vapor phase growth method for n-type SiC of this embodiment, a Si (silicon) source gas, a C (carbon) source gas, an n-type impurity source gas, and a p-type impurity source gas are simultaneously supplied into a substrate or seed crystals in the reaction chamber, to grow n-type SiC. Where the p-type impurity is an element A and the n-type impurity is an element D, the element A and the element D form a combination of Al (aluminum), Ga (gallium), or In (indium) and N (nitrogen), and/or a combination of B (boron) and P (phosphorus). The amounts (flow rates) of the p-type impurity source gas and the n-type impurity source gas are controlled so that the ratio of the concentration of the element A to the concentration of the element D in the combination in the n-type SiC being grown becomes higher than 0.40 but lower than 0.95.

The concentration of the element D in the n-type SiC film to be formed by the vapor phase growth method of this embodiment is not lower than 1 × 10¹⁵ cm⁻³ and not higher than 1 × 10²² cm⁻³, for example.

In the case of the first combination of Al (aluminum), Ga (gallium), or In (indium) and N (nitrogen), for example, the element A may be a single element selected from Al (aluminum), Ga (gallium), and In (indium). Alternatively, the element A may be formed with two elements such as Al (an element A₁) and Ga (an element A₂) or may be formed with three elements such as Al (the element A₁), Ga (the element A₂), and In (an element A₃). In a case where the element A is formed with more than one element, the element A may be formed with two or three kinds of elements, as long as the above described conditions on the ratio of the concentration of the element A to the concentration of the element D and on the concentration of the element D are satisfied.

The first combination and the second combination can coexist. However, the above described conditions on the ratio of the concentration of the element A to the concentration of the element D and on the concentration of the element D should be satisfied with elements that form at least one of the first and second combinations. In other words, each of the first combination and the second combination should satisfy the conditions on the element ratio and the element concentration. This is because the later described trimers are not formed between an impurity in the first combination and an impurity in the second combination.

In the following, an example case where the element A is Al (aluminum) and the element D is N (nitrogen) is described.

First, a semiconductor wafer W is placed on the supporting unit 14 in the reaction chamber 10. The semiconductor wafer W is an n-type SiC substrate that contains P (phosphorus) or N (nitrogen) as the n-type impurity at an impurity concentration of approximately 5 × 10¹⁸ cm⁻³, for example, has a thickness of 300 µm, for example, and has a low resistance of 4H-SiC.

Here, the gate valve (not shown) of the wafer entrance of the reaction chamber 10 is opened, and the semiconductor wafer W in a load lock chamber is transported into the reaction chamber 10 with a handling arm. The semiconductor wafer W is then placed on the supporting unit 14 via the upthrust pin (not shown), for example, the handling arm is retracted into the load lock chamber, and the gate valve is closed.

The vacuum pump (not shown) is then activated, to discharge the gas in the reaction chamber 10 through the gas emission unit 28 and adjust the inside of the reaction chamber 10 to a predetermined degree of vacuum. Here, the semiconductor wafer W placed on the supporting unit 14 is preheated to a predetermined temperature by the heating unit 18. Further, the heating power of the heating unit 18 is increased, and the semiconductor wafer W is heated to an SiC epitaxial growth temperature. The growth temperature is 1600 to 1750°C, for example.

The evacuation with the vacuum pump is continued, and the rotator unit 16 is rotated at a required speed. The Si (silicon), C (carbon), N (nitrogen), and Al (aluminum) source gases that are supplied from the first through fourth gas supply sources 41 through 44 and have flow rates adjusted by the mass flow controllers 51 through 52 are mixed, and are then injected through the gas supply unit 12. The source gases may be injected into the reaction chamber 10 through different nozzles from one another, for example, and may be mixed in the reaction chamber 10.

The Si (silicon) source gas may be monosilane (SiH₄) having a hydrogen gas (H₂) as the carrier gas, for example. The C (carbon) source gas may be propane (C₃H₈) having a hydrogen gas as the carrier gas, for example. The N (nitrogen) source gas may be a nitrogen gas (N₂) diluted with a hydrogen gas, for example. The Al (aluminum) source gas may be trimethylaluminum (TMA) that is bubbled with a hydrogen gas (H₂) and has the hydrogen gas (H₂) as the carrier gas, for example.

When the source gases are supplied, the control signal generating unit 60 generates control signals defining such flow rates that the ratio of the Al concentration to the N concentration (Al concentration/N concentration) in the SiC being grown becomes higher than 0.40 but lower than 0.95.

The mixed gas of the Si (silicon), C (carbon), N (nitrogen), and Al (aluminum) source gases injected through the gas supply unit 12 is supplied in a rectified state onto the semiconductor wafer W. As a result, an n-type SiC single-crystal film is formed on the surface of the semiconductor wafer W through epitaxial growth.

When the epitaxial growth ends, the source gas injection through the gas supply unit 12 is stopped, the supply of the source gases onto the semiconductor wafer W is shut off, and the growth of the single-crystal film is ended.

After the film formation, the temperature of the semiconductor wafer W starts dropping. Here, the rotation of the rotator unit 16 is stopped, and the semiconductor wafer W having the single-crystal film formed thereon is left on the supporting unit 14. The heating power of the heating unit 18 is then returned to the initial value, and is adjusted to the preheating temperature of 600°C or lower, for example.

After the temperature of the semiconductor wafer W is stabilized at a predetermined temperature, the semiconductor wafer W is detached from the supporting unit 14 with the upthrust pin, for example. The gate valve is again opened, the handling arm is inserted, and the semiconductor wafer W is placed on the handling arm. The handling arm having the semiconductor wafer W placed thereon is then returned into the load lock chamber.

Film formation on the semiconductor wafer W is completed in the above described manner, and film formation may be continued on another semiconductor wafer W in the same process sequence as above, for example.

The concentration of N (nitrogen) in n-type SiC to be formed by the vapor phase growth method of this embodiment is not lower than 1 × 10¹⁵ cm⁻³ and not higher than 1 × 10²² cm⁻³, for example. According to the vapor phase growth method of this embodiment, co-doping is performed with N and Al at a predetermined ratio. As a result, the solid solubility limit of N is raised, donor levels become shallower, and low-resistance n-type SiC is realized. Further, generation of defects is restrained, and high-quality n-type SiC is realized.

In this embodiment, n-type SiC is grown from a vapor phase. As diffusion in a vapor phase is much larger than that in a solid phase, interaction between N and Al occurs more easily than in a solid phase. As a result, trimer formation in SiC is facilitated. Accordingly, the effects of co-doping can be more easily achieved.

Particularly, in this embodiment, the effects of co-doping can be easily achieved by co-doping through ion implantation, even when the concentration of N is in a relatively low-concentration range in which trimer formation is difficult, or when the N concentration is not lower than 1 × 10¹⁵ cm⁻³ and not higher than 1 × 10¹⁸ cm⁻³.

More particularly, when the N concentration is within a low-concentration range of 1 × 10¹⁵ to 1 × 10¹⁸ cm⁻³, donor levels can be made shallower. Accordingly, a reduction in resistance can be easily realized while the withstand voltage of SiC is maintained, compared with a case where co-doping is not performed and donor levels are deep. In this manner, this embodiment can form an SiC film that is suitable as the drift layer of a vertical MOSFET (Metal Oxide Semiconductor Field Effect Transistor) or a vertical IGBT (Insulated Gate Bipolar Transistor).

So as to form n-type SiC having a lower resistance, the flow rates of the Al source gas and the N source gas are preferably adjusted so that the ratio of the Al concentration to the N concentration in the n-type SiC being grown becomes not lower than 0.45 and not higher than 0.75. More preferably, the flow rates of the Al source gas and the N source gas are adjusted so that the ratio of the Al concentration to the N concentration becomes not lower than 0.47 and not higher than 0.60.

Next, a method of growing p-type SiC is described.

According to the vapor phase growth method for p-type SiC of this embodiment, a Si (silicon) source gas, a C (carbon) source gas, an n-type impurity source gas, and a p-type impurity source gas are simultaneously supplied into a substrate or seed crystals in the reaction chamber, to grow p-type SiC. Where the p-type impurity is an element A and the n-type impurity is an element D, the element A and the element D form a combination of Al (aluminum), Ga (gallium), or In (indium) and N (nitrogen), and/or a combination of B (boron) and P (phosphorus). In other words, the element A and the element D form at least a first combination or a second combination, the first combination being a combination of the element A selected from a group consisting of Al (aluminum), Ga (gallium), and In (indium) and the element D being N (nitrogen), the second combination being a combination of the element A being B (boron) and the element D being P (phosphorus). The amounts (flow rates) of the p-type impurity source gas and the n-type impurity source gas are controlled so that the ratio of the concentration of the element D to the concentration of the element A in the combination in the p-type SiC being grown becomes higher than 0.33 but lower than 1.0.

The concentration of the element A in the p-type SiC film to be formed by the vapor phase growth method of this embodiment is not lower than 1 × 10¹⁵ cm⁻³ and not higher than 1 × 10²² cm⁻³, for example.

In the case of the first combination of Al (aluminum), Ga (gallium), or In (indium) and N (nitrogen), for example, the element A may be a single element selected from Al (aluminum), Ga (gallium), and In (indium). Alternatively, the element A may be formed with two elements such as Al (an element A₁) and Ga (an element A₂) or may be formed with three elements such as Al (the element A₁), Ga (the element A₂), and In (an element A₃). In a case where the element A is formed with more than one element, the element A may be formed with two or three kinds of elements, as long as the above described conditions on the ratio of the concentration of the element D to the concentration of the element A and on the concentration of the element A are satisfied.

The first combination and the second combination can coexist. However, the above described conditions on the ratio of the concentration of the element D to the concentration of the element A and on the concentration of the element A should be satisfied with elements that form at least one of the first and second combinations. In other words, each of the first combination and the second combination should satisfy the conditions on the element ratio and the element concentration. This is because trimers are not formed between an impurity in the first combination and an impurity in the second combination.

In the following, an example case where the element A is Al (aluminum) and the element D is N (nitrogen) is described.

The vapor phase growth method for p-type SiC differs from the vapor phase growth method for n-type SiC in the flow rates of the N (nitrogen) source gas and the Al (aluminum) source gas. Explanation of the same aspects as those of the vapor phase growth method for n-type SiC will not be repeated.

When the source gases are supplied, the control signal generating unit 60 generates control signals defining such flow rates that the ratio of the N concentration to the Al concentration (N concentration/Al concentration) in the p-type SiC being grown becomes higher than 0.33 but lower than 1.0.

In the vapor phase growth of p-type SiC, the mixed gas of the Si (silicon), C (carbon), N (nitrogen), and Al (aluminum) source gases injected through the gas supply unit 12 is supplied in a rectified state onto a semiconductor wafer W. As a result, a p-type SiC single-crystal film is formed on the surface of the semiconductor wafer W through epitaxial growth.

The concentration of Al (aluminum) in p-type SiC to be formed by the vapor phase growth method of this embodiment is not lower than 1 × 10¹⁵ cm⁻³ and not higher than 1 × 10²² cm⁻³, for example. According to the vapor phase growth method of this embodiment, co-doping is performed with N and Al at a predetermined ratio. As a result, the solid solubility limit of Al is raised, acceptor levels become shallower, and low-resistance p-type SiC is realized. Further, generation of defects is restrained, and high-quality p-type SiC is realized.

In this embodiment, p-type SiC is grown from a vapor phase. As diffusion in a vapor phase is much larger than that in a solid phase, interaction between N and Al occurs more easily than in a solid phase. As a result, trimer formation in SiC is facilitated. Accordingly, the effects of co-doping can be more easily achieved.

Particularly, in this embodiment, the effects of co-doping can be easily achieved by co-doping through ion implantation, even when the concentration of Al is in a relatively low-concentration range in which trimer formation is difficult, or when the Al concentration is not lower than 1 × 10¹⁵ cm⁻³ and not higher than 1 × 10¹⁹ cm⁻³. The effects of co-doping are easily achieved by co-doping through ion implantation, even when the concentration of Al is in a relatively low-concentration range in which trimer formation is even more difficult, or when the Al concentration is not lower than 1 × 10¹⁵ cm⁻³ and not higher than 1 × 10¹⁸ cm⁻³.

More particularly, when the Al concentration is within a low-concentration range of 1 × 10¹⁵ to 1 × 10¹⁸ cm⁻³, acceptor levels can be made shallower. Accordingly, a reduction in resistance can be easily realized while the withstand voltage of SiC is maintained, compared with a case where co-doping is not performed and acceptor levels are deep.

So as to form p-type SiC having a lower resistance, the flow rates of the Al source gas and the N source gas are preferably adjusted so that the ratio of the N concentration to the Al concentration in the p-type SiC being grown becomes not lower than 0.40 and not higher than 0.95. Further, the flow rates of the Al source gas and the N source gas are preferably adjusted so that the ratio of the N concentration to the Al concentration becomes not lower than 0.45 and not higher than 0.75. More preferably, the flow rates of the Al source gas and the N source gas are adjusted so that the ratio of the N concentration to the Al concentration becomes not lower than 0.47 and not higher than 0.60.

### (Second Embodiment)

A vapor phase growth method for SiC of this embodiment differs from that of the first embodiment in that p-type SiC is successively formed on n-type SiC, or n-type SiC is successively formed on p-type SiC. In the following, explanation of the same aspects of those of the first embodiment will not be repeated.

The vapor phase growth method of this embodiment is implemneted by the epitaxial growth apparatus 100 shown in FIG. 1, for example. The epitaxial growth apparatus 100 shown in FIG. 1 can supply both an n-type impurity source gas such as an N (nitrogen) source gas and a p-type impurity source gas such as an Al (aluminum) source gas into the reaction chamber 10. Accordingly, an n-type SiC film and a p-type SiC film can be successively grown in the same reaction chamber 10.

First, an example case where a p-type SiC film is formed on an n-type SiC film is described. First, by the method of growing n-type SiC described in the first embodiment, a Si (silicon) source gas, a C (carbon) source gas, an n-type impurity source gas such as an N (nitrogen) source gas, and a p-type impurity source gas such as an Al (aluminum) source gas are simultaneously supplied to a semiconductor wafer W (substrate) held in the reaction chamber 10, to grow n-type SiC. In growing the n-type SiC, the flow rates of the p-type impurity source gas and the n-type impurity source gas are adjusted so that the ratio of the p-type impurity concentration to the n-type impurity concentration in the n-type SiC being grown becomes higher than 0.40 but lower than 0.95.

After the n-type SiC is grown, p-type SiC is grown on the n-type SiC in the same reaction chamber 10. In growing the p-type SiC, the flow rates of the n-type impurity source gas and the p-type impurity source gas are adjusted so that the ratio of the n-type impurity concentration to the p-type impurity concentration in the p-type SiC being grown becomes higher than 0.33 but lower than 1.0.

According to this embodiment, a p-type SiC film is successively formed on an n-type SiC film in the same reaction chamber 10. Accordingly, the temperature lowering step for transporting the semiconductor wafer W to and from the reaction chamber 10 becomes unnecessary. Thus, a low-resistance stack structure formed with an n-type SiC film and a p-type SiC film can be manufactured at high throughput.

Also, by virtue of the successive film formation, dust and the like that accumulate in the films during the transportation are reduced, and high-quality SiC can be manufactured.

Next, an example case where an n-type SiC film is formed on a p-type SiC film is described. First, by the method of growing p-type SiC described in the first embodiment, a Si (silicon) source gas, a C (carbon) source gas, an n-type impurity source gas such as an N (nitrogen) source gas, and a p-type impurity source gas such as an Al (aluminum) source gas are simultaneously supplied to a semiconductor wafer W (substrate) held in the reaction chamber 10. The flow rates of the N source gas and the Al source gas are adjusted so that the ratio of the n-type impurity concentration to the p-type impurity concentration in the SiC being grown becomes higher than 0.33 but lower than 1.0, and p-type SiC is grown.

After the p-type SiC is grown, n-type SiC is grown on the p-type SiC in the same reaction chamber 10. In growing the n-type SiC, the flow rates of the p-type impurity source gas and the n-type impurity source gas are adjusted so that the ratio of the p-type impurity concentration to the n-type impurity concentration in the n-type SiC being grown becomes higher than 0.40 but lower than 0.95.

Where the p-type impurity is an element A and the n-type impurity is an element D, the element A and the element D form a combination of Al (aluminum), Ga (gallium), or In (indium) and N (nitrogen), and/or a combination of B (boron) and P (phosphorus), as in the first embodiment.

According to this embodiment, an n-type SiC film is successively formed on a p-type SiC film in the same reaction chamber 10. Accordingly, the temperature lowering step for transporting the semiconductor wafer W to and from the reaction chamber 10 becomes unnecessary. Thus, a low-resistance stack structure formed with a p-type SiC film and an n-type SiC film can be manufactured at high throughput.

Also, by virtue of the successive film formation, dust and the like that accumulate in the films during the transportation are reduced, and high-quality SiC can be manufactured.

### (Third Embodiment)

This embodiment concerns a semiconductor device manufacturing method using the vapor phase growth method of the first or second embodiment. Explanation of the same aspects as those of the first and second embodiments will not be repeated.

In the following, an example case where an element A is Al (aluminum) and an element D is N (nitrogen) is described.

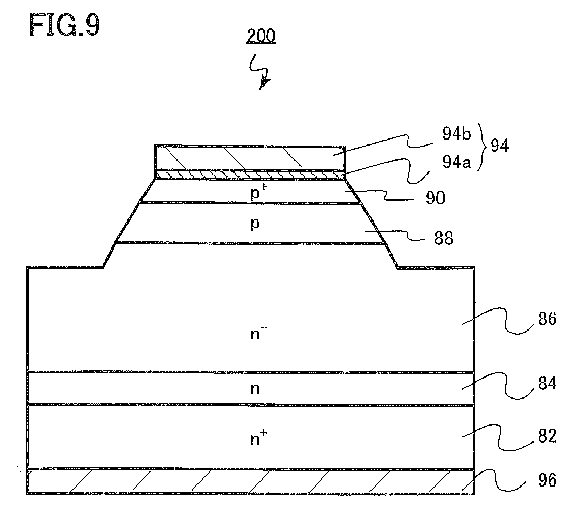

FIG. 9 is a schematic cross-sectional view of a semiconductor device manufactured according to this embodiment. The semiconductor device 200 is a mesa-type PiN diode.

This PiN diode 200 includes an n⁺-type SiC substrate (a silicon carbide substrate) 82 having first and second faces. In FIG. 9, the first face is the upper face, and the second face is the lower face.

The SiC substrate 82 is a 4H-SiC substrate (an n-substrate) that contains N (nitrogen) as the n-type impurity at an impurity concentration of approximately 5 × 10¹⁸ to 1 × 10¹⁹ cm⁻³, for example. The first face may be a face inclined at four degrees to the (0001) plane, for example.

An n-type SiC layer (a buffer layer) 84 containing N at a concentration of approximately 1 × 10¹⁸ to 5 × 10¹⁸ cm⁻³ is formed on the first face of the SiC substrate 82. The film thickness of the n-type SiC layer 84 is approximately 0.5 to 3 µm, for example.

The n-type SiC layer 84 is co-doped with Al (aluminum) and N (nitrogen). The ratio of the Al concentration to the N concentration is higher than 0.40 but lower than 0.95.

An n⁻-type SiC layer 86 containing N at an impurity concentration of approximately 1 × 10¹⁵ to 2 × 10¹⁶ cm⁻³ is formed on the n-type SiC layer 84. The film thickness of the n⁻-type SiC layer 86 is approximately 5 to 50 µm, for example.

A p-type SiC layer 88 containing Al at an impurity concentration of approximately 1 × 10¹⁷ to 1 × 10¹⁸ cm⁻³ is formed on the surface of the n⁻-type SiC layer 86. The p-type SiC layer 88 is co-doped with N (nitrogen) and Al (aluminum). The ratio of the N concentration to the Al concentration is higher than 0.33 but lower than 1.0. The film thickness of the p-type SiC layer 88 is approximately 0.5 to 3 µm, for example.

A p⁺-type SiC layer 90 containing Al at an impurity concentration of approximately 1 × 10¹⁹ to 1 × 10²⁰ cm⁻³ is formed on the surface of the p-type SiC layer 88. The p⁺-type SiC layer 90 is co-doped with N (nitrogen) and Al (aluminum). The ratio of the N concentration to the Al concentration is higher than 0.33 but lower than 1.0. The film thickness of the p⁺-type SiC layer 90 is approximately 0.2 to 1 µm, for example.

A conductive anode electrode 94 that is electrically connected to the p⁺-type SiC layer 90 is provided. The anode electrode 94 is formed with a Ni (nickel) barrier metal layer 94a and an Al metal layer 94b formed on the barrier metal layer 94a, for example.

A conductive cathode electrode 96 is formed on the side of the second face of the n⁺-type SiC substrate 82. The cathode electrode 96 is made of Ni, for example.

Next, an example method of manufacturing the PiN diode 200 is described.

First, the n⁺-type SiC substrate 82 containing the n-type impurity at a concentration of 5 × 10¹⁸ cm⁻³ is prepared, for example.

The n-type SiC layer 84 of 1 µm in film thickness, for example, is then formed on the n⁺-type SiC substrate 82 with the epitaxial growth apparatus 100 shown in FIG. 1, for example. The epitaxial growth temperature is 1630°C, for example.

The Si (silicon) source gas may be 10%-diluted monosilane (SiH₄) having a hydrogen gas (H₂) as the carrier gas, for example. The C (carbon) source gas may be 10%-diluted propane (C₃H₈) having a hydrogen gas as the carrier gas, for example. The N (nitrogen) source gas may be a nitrogen gas (N₂) diluted to 10% with a hydrogen gas, for example. The Al (aluminum) source gas may be trimethylaluminum (TMA) having a hydrogen gas (H₂) as the carrier gas, for example. The trimethylaluminum (TMA) bubbled with a hydrogen gas (H₂) is supplied from a 15°C constant-temperature bath, for example. The C/Si ratio is 0.9, for example.

At this point, the flow rates of the Al source gas and the N source gas are adjusted by the control unit of the epitaxial growth apparatus 100 so that the Al concentration in the n-type SiC layer 84 being grown becomes 1 × 10¹⁸ cm⁻³, and the N concentration becomes 2 × 10¹⁸ cm⁻³ (Al concentration/N concentration = 0.5), for example.

In the same reaction chamber 10, the n⁻-type SiC layer 86 of 40 µm in film thickness, for example, is then formed on the n-type SiC layer 84. The conditions for the formation are the same as those in the case of the n-type SiC layer 84, except for the flow rates of the source gases.

At this point, the flow rates of the Al source gas and the N source gas are adjusted by the control unit so that the Al concentration in the n-type SiC layer 86 being grown becomes 3 × 10¹⁵ cm⁻³, and the N concentration becomes 6 × 10¹⁵ cm⁻³ (Al concentration/N concentration = 0.5), for example.

In the same reaction chamber 10, the p-type SiC layer 88 of 1.5 µm in film thickness, for example, is then formed on the n⁻-type SiC layer 86. The epitaxial growth temperature is 1630°C, for example.

The Si (silicon) source gas may be 10%-diluted monosilane (SiH₄) having a hydrogen gas (H₂) as the carrier gas, for example. The C (carbon) source gas may be 10%-diluted propane (C₃H₈) having a hydrogen gas as the carrier gas, for example. The N (nitrogen) source gas may be a nitrogen gas (N₂) diluted to 10% with a hydrogen gas, for example. The Al (aluminum) source gas may be trimethylaluminum (TMA) having a hydrogen gas (H₂) as the carrier gas, for example. The trimethylaluminum (TMA) bubbled with a hydrogen gas (H₂) is supplied from a 15°C constant-temperature bath, for example. The C/Si ratio is 1.1, for example.

At this point, the flow rates of the Al source gas and the N source gas are adjusted by the control unit so that the N concentration in the p-type SiC layer 88 being grown becomes 1 × 10¹⁷ cm⁻³, and the Al concentration becomes 2 × 10¹⁷ cm⁻³ (N concentration/Al concentration = 0.5), for example.

In the same reaction chamber 10, the p⁺-type SiC layer 90 of 0.5 µm in film thickness, for example, is then formed on the p-type SiC layer 88. The conditions for the formation are the same as those in the case of the p-type SiC layer 88, except for the flow rates of the source gases.

At this point, the flow rates of the Al source gas and the N source gas are adjusted by the control unit so that the N concentration in the p⁺-type SiC layer 90 being grown becomes 1 × 10¹⁹ cm⁻³, and the Al concentration becomes 2 × 10¹⁹ cm⁻³ (N concentration/Al concentration = 0.5), for example.

After that, a mesa structure is formed by a known process. Further, the anode electrode 94 and the cathode electrode 96 are formed by a known process, and the PiN diode 200 is completed.

According to this embodiment, the PiN diode 200 is formed by using an epitaxial wafer formed through co-doping epitaxial growth. Accordingly, the high-performance, high-voltage PiN diode 200 is realized.

Also, as n-type and p-type epitaxial films are successively formed in the same reaction chamber 10, the manufacturing time for the PiN diode 200 can be shortened. For example, the process time can be shortened by almost an hour and a half.

### (Fourth Embodiment)

A vapor phase growth apparatus of this embodiment is an apparatus for growing SiC. The vapor phase growth apparatus includes: a reaction chamber; a first gas supply channel that supplies a Si (silicon) source gas to the reaction chamber; a second gas supply channel that supplies a C (carbon) source gas to the reaction chamber; a third gas supply channel that supplies an n-type impurity source gas to the reaction chamber; a fourth gas supply channel that supplies a p-type impurity source gas to the reaction chamber; and a control unit that controls the amounts (flow rates) of the n-type impurity and p-type impurity source gases at a predetermined ratio, and introduces the n-type impurity and p-type impurity source gases into the reaction chamber. If the p-type impurity is an element A and the n-type impurity is an element D, the element A and the element D form a combination of Al (aluminum), Ga (gallium), or In (indium) and N (nitrogen), and/or a combination of B (boron) and P (phosphorus).

The effects and the like of co-doping with a p-type impurity and an n-type impurity at a predetermined ratio are the same as those of the first embodiment, and therefore, explanation of them will not be repeated. In the following, an example case where the element A is Al (aluminum) and the element D is N (nitrogen) is described.

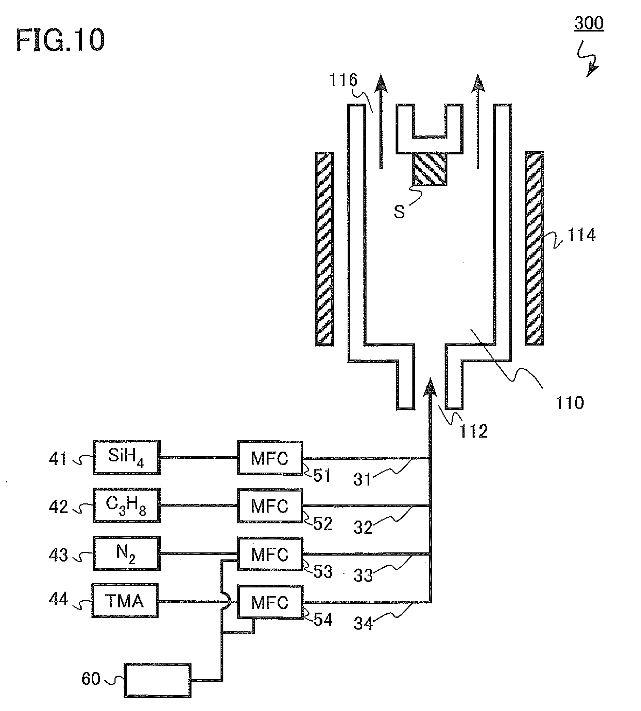

FIG. 10 is a schematic cross-sectional view of the vapor phase growth apparatus of this embodiment. The vapor phase growth apparatus of this embodiment is a vapor phase growth apparatus that uses high-temperature CVD (HTCVD). The vapor phase growth apparatus of this embodiment forms n-type or p-type SiC single crystals through epitaxial growth from seed crystals.

As shown in FIG. 10, the vapor phase growth apparatus 300 of this embodiment includes a cylindrical, hollow reaction chamber 110 that is made of quartz glass, for example. A gas supply unit 112 is placed under the reaction chamber 110, and supplies process gases into the reaction chamber 110.

The seed crystals S of SiC are rotatably held at an upper portion in the reaction chamber 110. A heater as a heating unit 114 that heats the seed crystals S and the source gases with radiation heat is provided to surround the reaction chamber 110.

Further, a gas emission unit 116 that discharges the reaction product generated after a source gas reaction on the seed crystals S and the residual gas in the reaction chamber 110 out of the reaction chamber 110 is provided at an upper portion of the reaction chamber 110.

The vapor phase growth apparatus 300 of this embodiment further includes a first gas supply channel 31 that supplies a Si (silicon) source gas to the reaction chamber 110, a second gas supply channel 32 that supplies a C (carbon) source gas to the reaction chamber 110, a third gas supply channel 33 that supplies an N (nitrogen) source gas to the reaction chamber 110, and a fourth gas supply channel 34 that supplies an Al (aluminum) source gas to the reaction chamber 110.

The first gas supply channel 31 is connected to a first gas supply source 41, the second gas supply channel 32 is connected to a second gas supply source 42, the third gas supply channel 33 is connected to a third gas supply source 43, and the fourth gas supply channel 34 is connected to a fourth gas supply source 44. The first through fourth gas supply sources 41 through 44 are gas cylinders filled with the respective source gases, for example.

The Si (silicon) source gas may be monosilane (SiH₄) having a hydrogen gas (H₂) as the carrier gas, for example. The C (carbon) source gas may be propane (C₃H₈) having a hydrogen gas as the carrier gas, for example. The N (nitrogen) source gas may be a nitrogen gas (N₂) diluted to 10% with a hydrogen gas, for example. The Al (aluminum) source gas may be trimethylaluminum (TMA) that is bubbled with a hydrogen gas (H₂) and has the hydrogen gas (H₂) as the carrier gas, for example.

The vapor phase growth apparatus 300 of this embodiment further includes: a mass flow controller 51 that is connected to the first gas supply source 41 and adjusts the flow rate of the Si (silicon) source gas; a mass flow controller 52 that is connected to the second gas supply source 42 and adjusts the flow rate of the C (carbon) source gas; a mass flow controller (a first adjusting unit) 53 that is connected to the third gas supply source 43 and adjusts the flow rate of the N (nitrogen) source gas; and a mass flow controller (a second adjusting unit) 54 that is connected to the fourth gas supply source 44 and adjusts the flow rate of the Al (aluminum) source gas.

The vapor phase growth apparatus 300 also includes a control signal generating unit 60 that generates control signals that set flow rates in the first adjusting unit 53 and the second adjusting unit 54. The first adjusting unit 53 and the second adjusting unit 54, and the control signal generating unit 60 constitute the control unit that adjusts the flow rates of the N source gas and the Al source gas to desired flow rates.

The control signal generating unit 60 may be a computer that has the function to calculate such flow rates of the N source gas and the Al source gas that realize a desired concentration ratio between N and Al in the SiC film being formed, for example. The control signal generating unit 60 generates control signals by calculating the flow rates required for the N source gas and the Al source gas based on the concentration ratio between N and Al in SiC that is input from an external input device and is to be realized.

Next, an SiC single crystal manufacturing method using the vapor phase growth apparatus 300 is described. First, a method of growing n-type SiC single crystals is described.

According to the vapor phase growth method for n-type SiC of this embodiment, a Si (silicon) source gas, a C (carbon) source gas, an N (nitrogen) source gas, and an Al (aluminum) source gas are simultaneously supplied into the seed crystals held in the reaction chamber 110, to grow SiC. In growing the n-type SiC, the flow rates of the Al source gas and the N source gas are adjusted so that the ratio of the Al concentration to the N concentration in the n-type SiC being grown becomes higher than 0.40 but lower than 0.95.

First, the seed crystals S of SiC single crystals are held in the reaction chamber 110, and are rotated. The heating power of the heating unit 114 is increased to raise the temperature of the seed crystals S. The temperature is 1900 to 2300°C, for example.

The Si (silicon), C (carbon), N (nitrogen), and Al (aluminum) source gases that are supplied from the first through fourth gas supply sources 41 through 44 and have flow rates adjusted by the mass flow controllers 51 through 52 are mixed, and are then injected through the gas supply unit 112.

The Si (silicon) source gas may be monosilane (SiH₄) having a hydrogen gas (H₂) as the carrier gas, for example. The C (carbon) source gas may be propane (C₃H₈) having a hydrogen gas as the carrier gas, for example. The N (nitrogen) source gas may be a nitrogen gas (N₂), for example. The Al (aluminum) source gas may be trimethylaluminum (TMA) that is bubbled with a hydrogen gas (H₂) and has the hydrogen gas (H₂) as the carrier gas, for example.

When the source gases are supplied, the control signal generating unit 60 generates control signals defining such flow rates that the ratio of the Al concentration to the N concentration (Al concentration/N concentration) in the SiC being grown becomes 0.5, for example.

The mixed gas of the Si (silicon), C (carbon), N (nitrogen), and Al (aluminum) source gases injected through the gas supply unit 112 is supplied in a rectified state onto the seed crystals S. As a result, n-type SiC single crystals are formed on the surfaces of the seed crystals S through epitaxial growth. The n-type SiC single crystals grown on the seed crystals S expand in the vertical direction in the reaction chamber 110, for example.

When the epitaxial growth ends, the source gas injection through the gas supply unit 112 is stopped, the supply of the source gases onto the seed crystals S is shut off, and the growth of the SiC single crystals is ended. After the SiC film formation, the temperature of the SiC single crystals starts dropping.

The method of growing p-type SiC single crystals is the same as the method of growing n-type SiC single crystals, except for the flow rates of the source gases.

In growing p-type SiC, the flow rates of the N source gas and the Al source gas are adjusted so that the ratio of the N concentration to the Al concentration in the p-type SiC being grown becomes higher than 0.33 but lower than 0.90. The ratio of the N concentration to the Al concentration is adjusted to 0.5, for example.

With the vapor phase growth apparatus 300 of this embodiment, SiC can be manufactured by simultaneously supplying an N (nitrogen) source gas as the n-type impurity and an Al (aluminum) source gas as the p-type impurity. Accordingly, SiC single crystals co-doped with N (nitrogen) as the n-type impurity and Al (aluminum) as the p-type impurity can be manufactured.

Further, with the control unit that adjusts the flow rate ratio between the N source gas and the Al source gas, the flow rates of the N source gas and the Al source gas can be adjusted to desired flow rates. Accordingly, the ratio between the Al concentration and the N concentration in the SiC being grown can be adjusted to a desired ratio.

Low-resistance SiC can be realized by co-doping SiC with N (nitrogen) as the n-type impurity and Al (aluminum) as the p-type impurity at a predetermined ratio as described above.

Particularly, the control unit is preferably designed to adjust the flow rates of the Al source gas and the N source gas so that the ratio of the Al concentration to the N concentration in the SiC being grown becomes higher than 0.40 but lower than 0.95, or the ratio of the N concentration to the Al concentration in the SiC becomes higher than 0.33 but lower than 1.0.

Although SiC (silicon carbide) crystalline structures are 4H-SiC structures in the above described embodiments, the embodiments can also be applied to other crystalline structures such as 6H-SiC and 3C-SiC structures.

Also, in the above described embodiments, the combination of a p-type impurity and an n-type impurity is a combination of Al (aluminum) and N (nitrogen). However, the combination is not limited to that, and the same effects as above can be achieved, as long as the combination is either a combination of Al (aluminum), Ga (gallium), or In (indium) and N (nitrogen), or a combination of B (boron) and P (phosphorus).

Although SiC is grown on SiC through homoepitaxial growth in the above embodiments, the embodiments can be applied to heteroepitaxial growth to grow SiC on a substrate made of a different material from SiC.

Also, in the above embodiments the vapor phase growth apparatuses are a single wafer processing epitaxial growth apparatus and an HTCVD apparatus as examples. However, the embodiments can also be applied to other vapor phase growth apparatuses such as an apparatus of a planetary type.

In the vapor phase growth apparatus of the first and fourth embodiments, one gas supply channel is prepared for each of N and Al. However, two gas supply channels may be prepared for each element. In that case, a mass flow controller for a higher flow rate and a mass flow controller for a lower flow rate are prepared for each element so that high-precision concentration control can be realized over a wide concentration range.

While certain embodiments have been described, these embodiments have been presented by way of example only, and are not intended to limit the scope of the inventions. Indeed, the vapor phase growth apparatus and the vapor phase growth method described herein may be embodied in a variety of other forms; furthermore, various omissions, substitutions and changes in the form of the devices and methods described herein may be made without departing from the spirit of the inventions. The accompanying claims and their equivalents are intended to cover such forms or modifications as would fall within the scope and spirit of the inventions.

## Claims

1. A vapor phase growth apparatus comprising:
a reaction chamber;
a first gas supply channel supplying an Si (silicon) source gas to the reaction chamber;
a second gas supply channel supplying a C (carbon) source gas to the reaction chamber;
a third gas supply channel supplying an n-type impurity source gas to the reaction chamber;
a fourth gas supply channel supplying a p-type impurity source gas to the reaction chamber; and
a control unit controlling amounts of the n-type impurity source gas and the p-type impurity source gas at a predetermined ratio, and introduce the n-type impurity source gas and the p-type impurity source gas into the reaction chamber,
wherein, when the p-type impurity is an element A and the n-type impurity is an element D, the element A and the element D form at least a first combination or a second combination, the first combination being a combination of the element A selected from a group consisting of Al (aluminum), Ga (gallium), and In (indium) and the element D being N (nitrogen), the second combination being a combination of the element A being B (boron) and the element D being P (phosphorus).

2. The apparatus according to claim 1, wherein the control unit controls the amounts of the p-type impurity source gas and the n-type impurity source gas to adjust a ratio of a concentration of the element A to a concentration of the element D forming at least one of the combinations in SiC being grown to a value that is larger than 0.40 but smaller than 0.95, or adjust a ratio of the concentration of the element D to the concentration of the element A forming at least one of the combinations in the SiC being grown to a value that is larger than 0.33 but smaller than 1.0.

3. The apparatus according to claim 1, wherein the control unit includes:
a first adjusting unit connected to the third gas supply channel;
a second adjusting unit connected to the fourth gas supply channel; and
a control signal generating unit supplying a control signal designating a source gas amount to the first adjusting unit and the second adjusting unit.

4. A vapor phase growth method for growing n-type SiC by supplying an Si (silicon) source gas, a C (carbon) source gas, an n-type impurity source gas, and a p-type impurity source gas to a substrate or seed crystals,
the method comprising
controlling amounts of the p-type impurity source gas and the n-type impurity source gas to adjust a ratio of a concentration of an element A to a concentration of an element D in the n-type SiC being grown to a value that is larger than 0.40 but smaller than 0.95, when the p-type impurity is the element A, the n-type impurity is the element D, and the element A and the element D form at least a first combination or a second combination, the first combination being a combination of the element A selected from a group consisting of Al (aluminum), Ga (gallium), and In (indium) and the element D being N (nitrogen), the second combination being a combination of the element A being B (boron) and the element D being P (phosphorus).

5. The method according to claim 4, wherein the amounts of the p-type impurity source gas and the n-type impurity source gas are controlled to adjust the ratio of the concentration of the element A to the concentration of the element D in the n-type SiC being grown to a value that is not lower than 0.45 and not higher than 0.75.

6. The method according to claim 4, wherein the concentration of the element D is not lower than 1 × 10¹⁵ cm⁻³ and not higher than 1 × 10¹⁸ cm⁻³.

7. The method according to claim 4, further comprising, after the growing the n-type SiC,
growing p-type SiC on the n-type SiC in the same reaction chamber by controlling the amounts of the p-type impurity source gas and the n-type impurity source gas to adjust a ratio of the concentration of the element D to the concentration of the element A forming at least one of the combinations in the p-type SiC being grown to a value that is larger than 0.33 but smaller than 1.0.

8. A vapor phase growth method for growing p-type SiC by supplying an Si (silicon) source gas, a C (carbon) source gas, an n-type impurity source gas, and a p-type impurity source gas to a substrate or seed crystals,
the method comprising
controlling amounts of the p-type impurity source gas and the n-type impurity source gas to adjust a ratio of a concentration of an element D to a concentration of an element A in the p-type SiC being grown to a value that is larger than 0.33 but smaller than 1.0, when the p-type impurity is the element A, the n-type impurity is the element D, and the element A and the element D form at least a first combination or a second combination, the first combination being a combination of the element A selected from a group consisting of Al (aluminum), Ga (gallium), and In (indium) and the element D being N (nitrogen), the second combination being a combination of the element A being B (boron) and the element D being P (phosphorus).

9. The method according to claim 8, wherein the amounts of the p-type impurity source gas and the n-type impurity source gas are controlled to adjust the ratio of the concentration of the element D to the concentration of the element A in the p-type SiC being grown to a value that is larger than 0.45 but smaller than 0.95.

10. The method according to claim 8, wherein the concentration of the element A is not lower than 1 × 10¹⁵ cm⁻³ and not higher than 1 × 10¹⁸ cm⁻³.

11. The method according to claim 8, further comprising, after the growing the p-type SiC,
growing n-type SiC on the p-type SiC in the same reaction chamber by controlling the amounts of the p-type impurity source gas and the n-type impurity source gas to adjust a ratio of the concentration of the element A to the concentration of the element D forming at least one of the combinations in the n-type SiC being grown to a value that is larger than 0.40 but smaller than 0.95.
